(19) Europäisches Patentamt
European Patent Office
Office européen des brevets

(11) Publication number: **0 165 591**
**A2**

# (12) EUROPEAN PATENT APPLICATION

(21) Application number: 85107513.5

(22) Date of filing: 18.06.85

(51) Int. Cl.[4]: G 03 B 27/32
G 03 F 7/20, G 03 F 5/24
G 03 F 5/14

(30) Priority: 18.06.84 JP 126208/84
18.06.84 JP 91413/84 U

(43) Date of publication of application:
27.12.85 Bulletin 85/52

(84) Designated Contracting States:
DE FR GB

(71) Applicant: MITSUBISHI PAPER MILLS, LTD.
4-2, Marunouchi 3-chome
Chiyoda-ku Tokyo 100(JP)

(71) Applicant: DAINIPPON SCREEN MFG., CO., LTD.
1-1, Tenjinkitacho
Horikawadoriteranouchiagaru-4-chome
Kamikyo-ku Kyoto-shi Kyoto-fun(JP)

(72) Inventor: Kanada, Eiji c/o Kyoto Factory
Mitsubishi Paper Mills, Ltd. 6-6, Kaiden-1-chome
Nagaokakyo-shi(JP)

(72) Inventor: Miyasaka, Eiji
173-10, Oyabucho
Hikone-shi(JP)

(72) Inventor: Hirose, Iwao
720-48, Nishiimacho
Hikone-shi(JP)

(72) Inventor: Yamashita, Koji
81-19, Horiagecho
Omihachiman-shi(JP)

(72) Inventor: Kawai, Kenji
47, Togacho
Hikone-shi(JP)

(74) Representative: Eitle, Werner, Dipl.-Ing. et al,
Hoffmann, Eitle & Partner Patentanwälte Arabellastrasse 4
D-8000 München 81(DE)

## (54) Method for direct plate making.

(57) A method for the direct production of printing plates in which exposure of an image on a photosensitive lithographic plate and plate processing are conducted in daylight. A printing plate (1) overlaid with a contact screen (6) which is secured to a screen frame is disposed on a rest (5) in an area where light is shielded by a light shielding cover sheet (7). This area is evacuated so as to bring the plate into close contact with the contact screen (6). A continuous tone image of an original bearing the continuous tone color image and a line image is exposed on the plate (1). The vacuum state of the area is released with the light shielded state being maintained, and the screen frame with the contact screen (6) is drawn out of the range. The line image is exposed on the plate which is adhered to the rest by evacuating the light shielded area, and thereafter the plate is fed to a plate processing section and is processed there.

F I G. 3

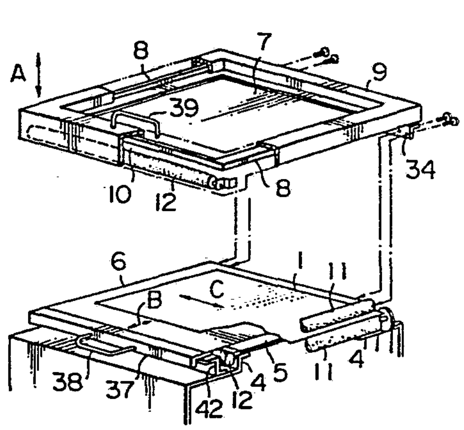

0165591

# METHOD FOR DIRECT PLATE MAKING

## BACKGROUND OF THE INVENTION

### Field of the Invention

The present invention relates to a method for the direct making of printing plate, and more particulary to a method for direct plate making from multicolor original.

### Description of the Prior Art

At present, a variety of sensitive materials convertible to lithographic printing plates are known and are in actual use. As typical examples, there may be mentioned presensitized plates (hereinafter referred to briefly as PS plates) employing diazonium compounds, electrophotographic plates employing zinc oxide or organic conductors, and silver salt photographic plates employing silver halide emulsions. Especially the photosensitive lithographic materials of high sensitivity such as the second and third ones of the above sensitive materials have come into remarkably wide use in the direct making of lithographic printing plates, because such sensitive materails can be treated conveniently and rapidly in an automatic printing plate processor throughout the process beginning with photographing of the original to be printed and including a sequence of processing steps.

Being very high in sensitivity, contrast, and resolving power, the silver salt sensitized material is especially useful. However, although having been imparted with excellent characteristics and improved quality, such sensitized materials are still unsuitable at present for use in the direct making of lithographic printing plates capable of reproducing multicolor prints from a continuous tone color original such as multicolor photographs. The reasons for this may be many, but one of the most important is a considerably inferior image reproducibility together with an insufficient printing endurance of the directly prepared printing plate as compared with a PS plate. As known well, the PS plate is imparted with a high image reproducibility through contact printing from an expensive lith film used as an intermediate original, whereas the direct plate making process involves photographing in a camera through a lens, which results in an unsatisfactory image reproducibility. As described in Japanese Patent Laid-open No. 89,007/73, the process camera includes a prism or a reflection mirror to obtain a laterally corrected image. Such a prism or mirror is known to exert an influence upon optical characteristics, resulting in deterioration of the image reproducibility. Every process camera now in general use photographs a reflected image. Accordingly, the originals to be photographed are so-called reflection images such as characters and

lines (these images are referred to as line images) formed on high-contrast image-forming materials employing an opaque support, such as photographic composing paper sheets or positive paper sheets used in the silver complex diffusion transfer process; or other reflection images such as a halftone dot image transformed from a continuous tone image, e.g., a photograph (these images are referred to as halftone dot images). A general practice is to arrange the reflection images according to a predetermined design and use as a finished original (block copy).

When a lithographic printing plate is directly made from a silver salt sensitized plate or electrophotographic plate with a reflection halftone dot image used as an original, there is reproduced a practically acceptable halftone dot image having a screen ruling of generally 80 or at most 100 lines per inch. Accordingly, even if black and white halftone dot images are prepared by using a panchromatically sensitized continuous tone film or lith film for color separation and if lithographic printing plates for color printing are prepared by the direct process from said halftone dot images used as an original, the resulting printing plates produce a printed color image with unsatisfactory image reproducibility and insufficient printing endurance.

Furthermore, though it is desirable to process

a printing plate in daylight as by the conventional processor, it is inconveniently impossible to make a lithographic printing plate for a multi-color printing with high resolution and sufficient printing endurance by means of the conventional processor.

SUMMARY OF THE INVENTION

Accordingly it is an object of the invention to provide an economical method enabling a printing plates, particularly printing plates for multicolor lithography, to be made directly in daylight with an easy processor operation and easy formation of a block copy and a method for obtaining with high resolution a number of prints which are faithful to the original.

According to one aspect of the invention, there is provided a method for the direct making of printing plates in which the steps of exposure of an image on a photosensitive lithographic plate and plate processing are conducted in daylight, the method comprising the steps of: disposing the plate on a rest in an area where light is shielded by a light shielding cover sheet with a contact screen secured to a screen frame, the plate being overlaid with the contact screen; exposing on the plate a continuous tone image of an original bearing the continuous tone image and a line image in the state wherein the area is evacuated and the plate and contact screen are in close contact; releasing the

vacuum within the area with the light shielded state being maintained, and drawing the screen frame integrally with the contact screen out of the portion; exposing on the plate the line image of the original in the state wherein the portion is evacuated and the plate and the rest are in close contact; and feeding the plate after the exposure to a plate processing section and processing the plate there.

According to another aspect of the invention, there is provided a method for the direct making of printing plates in which the steps of exposure of an image on a photosensitive lithographic plate and plate processing are conducted in daylight, the method comprising the steps of: disposing the plate on a rest in an area in which light is shielded by a light shielding cover sheet; exposing on the plate a line image of an original bearing a continuous tone image and the line image in the state where the area is evacuated and the plate and the rest are in close contact; releasing the vacuum within the area with the light shielded state being maintained, and inserting into the area a contact screen which is secured to a screen frame and disposing the contact screen in overlapped relation with the plate; exposing on the plate the continuous tone image of the original in the state where the area is evacuated and the plate and the contact screen are in close contact; and feeding the plate after the exposure

to a plate processing section and processing the plate there.

The present inventors had carried out an extensive study to improve the image reproducibility of a directly made lithographic printing plate and found that although the unsatisfactory reproducibility originates partly from the optical system such as a lens or a reflection mirror, it is possible to obtain a printing plate exhibiting a reproducibility favorably comparable to that obtained by use of a PS plate when a sensitive material bearing a panchromatically sensitized photographic layer is brought into close contact with a contact screen and exposed through a color separation filter, even thrugh an optical system such as a lens or a reflection mirror and a reflection block copy such as a continuous gradation reflection color original are used. The lithographic printing plate thus prepared showed a higher printing endurance, being capable of producing a greater number of copies, as compared with a printing plate made by the conventional method.

Thus, the use of a contact screen makes it possible to directly make a printing plate from a multicolor original and perfects the system of automatic plate making in daylight (in the state where the photosensitive lithographic plate is fixed on a rest where the light is shielded by a light shielding cover sheet without the need for being rewound into a cassette or

the like), and to photograph an original bearing continuous tone photographs or images scattered with line drawings or images such as letters and characters, with a simple operation by drawing out contact screen out of the light shielding cover sheet or inserting it into the light shielding cover. Especially in the direct production of printing plates for multicolor lithography, it is made possible to obtain a number of printings with an efficiently accurate positioning of each color plate and high color reproducibility of color images.

The sensitive material used in this invention must bear a panchromatically sensitized photographic layer, that is, sensitive to blue, green, and red and no matter what the type of sensitive layer may be; namely, whichever of the silver salt photographic layer, electrophotographic layer, and other sensitive layers may be used.

For instance, in the case of a sensitive material developable by the silver complex diffusion transfer process, spectral sensitizing dyes for green, red, and, if necessary, blue, respectively, may be selected from the spectral sensitizing dyes represented by the general formula described in Japanese Patent Laid-open No. 21,601/78.

It will be obvious that this invention is not only suitable for the direct making of multicolor lithography but also is useful for the direct production

of conventional monochrome type printing plates.

The above and other objects, features and advantages of the present invention will become clear from the following description of the preferred embodiments thereof, taken in conjunction with the accompanying drawings.

BRIEF DESCRIPTION OF THE DRAWINGS

Fig. 1 is a side elevational view of an example of a daylight processor used in a method for the direct making of printing plates according to this invention;

Fig. 2 is a sectional side elevational view of the vicinity of the photographing section of the processor shown in Fig. 1;

Fig. 3 is an exploded perspective view of a part of the vicinity of the photographing section shown in Fig. 2;

Fig. 4 is an enlarged view of a modification of the portion IV of the part shown in Fig. 3; and

Figs. 5 to 8 show various structures for facilitating carriage of the lithographic plate to the photographing section and the plate processing section of the processor.

DESCRIPTION OF THE PREFERRED EMBODIMENTS

A photosensitive lithographic printing plate

used for the invention may be produced by various methods. Examples of the methods for producing it will be described in the following based on the tests carried out by the inventors;

EXAMPLE

A gelatino silver chlorobromide emulsion containing 3 mole-% of silver bromide was prepared in a customary manner. The silver halide was 0.4 μm in average particle diameter. After chemical sensitization, the emulsion was panchromatically sensitized by the addition of dyes No. 1, No. 2, and No. 3 shown below. A stabilizer, hardener, and coating aid were added to prepare a coating solution.

An antihalation coating containing powdered silica of 7 μm in average particle size, hydroquinone, phenidone, and carbon black was applied onto a subbed polyester film base, 100 μm in thickness. The above-mentioned coating solution ($A_gNO_3$15 g/$m^2$) was coated over the antihalation coating layer.

Dye No. 1: 90 mg per mole of silver halide

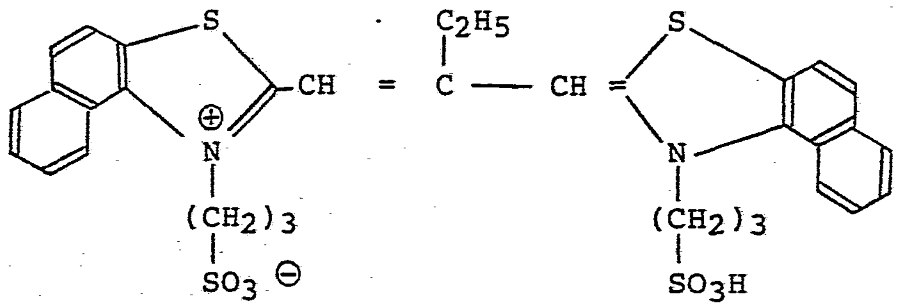

Dye No. 2: 700 mg per mole of silver halide

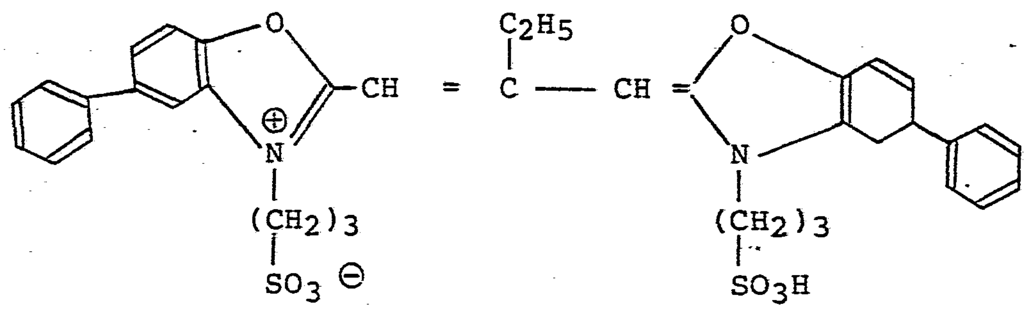

Dye No. 3: 500 mg per mole of silver halide

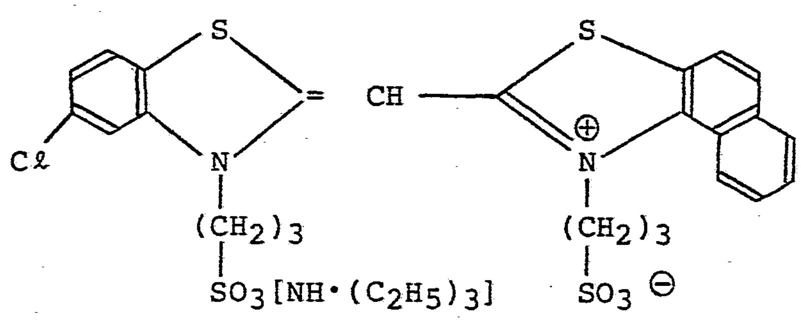

Onto the resulting emulsion layer, was applied a physical development nuclei coating containing palladium sulfide to produce a lithographic printing plate.

Fig. 1 is a side elevational view of an example of a daylight processor suitable for adopting the method according to the invention. Figs. 2 to 4 are a partially enlarged views of the processor shown in Fig. 1. In Fig. 1, the referential numeral 21 denotes a base frame. A camera obscura 22 is fixed on the base frame 21 and is connected to a lens 23 through bellows 24. A lens rack 25, a light source 26 and a copy rack 27 are slidably disposed on the frame 21. For reflection exposure it is preferable to provide a light source for a transmission exposure device (not shown) at the back of the copy rack 27, separately from the light source device 26. A color separation filter rack (not shown) is provided between the lens 23 and the bellows 24 whereby each color separation filter is set in a rotary system. The color separation filter rack may be situated in front of the lens 23. An image inversion mirror 28 is fixed in the camera obscura 22 and a photographing section 3 is provided on top of the camera obscura 22.

A photosensitive lithographic printing plate 1 is carried from a cassette 2 in which it is accommodated to the photographing section 3 and is exposed. The exposed printing plate 1 is carried to a plate processing section 40 having a developing tank and, if necessary, a neutralizing tank, a desensitizing tank, etc. built-in, is processed there and platemaking is thus completed.

Referring to Figs. 2 and 4, on the base 4 of the photographing section 3 a rest 5 including transparent glass is placed such as to form the image of an original image on the upper surface of the rest 5. The rest 5 is not necessarily horizontal but may be inclined. On one side of the base 4 is provided a pair of feed rollers 11, 11 for supplying the plate 1 onto the rest 5 with the end of the plate I clamped therebetween and for transferring the exposed plate 1 to the plate processing section 40. A guide 29 connects these feed rollers 11, 11 to the cassette 2 which houses the plate 1 in a rolled form. A mobile rotary blade type cutter 31 is provided in the vicinity of the plate outlet 30 of the cassette 2 such that the plate 1 may be cut off by manually operating the handle 33 of the cutter 31 at the time when a predetermined length of the plate 1 is fed from the cassette 2 by supply rollers 32. These supply rollers 32 and the feed rollers 11 are so constituted as to be interlocked by a driving device (not shown) and it is possible to interlock the cutter with them, if necessary.

In Fig. 2, the cassette 2 may be disposed on the opposite side of the plate processing section 40 in

relation to the feed rollers 11, 11 (i.e. the cassette 2 and the like may be located under the rollers 11, 11, while the processing section 40 is placed above the rollers 11, 11), and in this case, another pair of rollers may be disposed on the opposite side of the rollers 11, 11.

In Fig. 3, a light shielding frame 9 is attached to the base 4 such as to be opened and closed by a hinge 34. The frame 9 has a cross sectional configuration opening which is substantially in the shape of an inverted U with the side facing toward the base 4. As is shown in Fig. 2, a frame member 8 with a light shielding cover sheet 7 stretched thereon and having an L-shaped configuration in cross section is mounted on the opening portion 10 of the frame 9. One side of the frame member 8 is fixed within the opening portion 10 of the light shielding frame 9 through the hinge 35, and the opposing side is fitted in the opening portion 10 through a controlling means such as a cam 36 in such a manner as to be vertically movable, whereby, as will be described later, the light shielding cover sheet 7 on the side from which the plate 1 is supplied lifted up as occasion demands by controlling the space formed between the rest 5 and the light shielding cover sheet 7 by use of the controlling means such as the cam 36 by turning a knob 36', for example.

One roller 12 formed of an elastic material is

provided on the side of the base 4 adjacent ot the side where the feed rollers 11, 11 are provided, namely, on the front side of the base 4, as a light shielding means which is required at the time of drawing out a contact screen 6, and the other roller 12 is, also formed of an elastic member, rotatably provided in the opening portion 10 of the light shielding frame 9.

At least one side of the contact screen 6 is stuck to a screen frame 37 having a pull 38. When installing the contact screen 6, the light shielding frame 9 is first opened in the direction indicated by the arrow A by grasping a pull 39, and the screen frame 37 is placed on the rest 5 such as to be secured to a ruling side 42 provided on the base 4. At this time the light shielding frame 9 is maintained in the open state by a spring member (not shown) provided on the hinge 34.

The ight shielding frame 9 is next opened and the contact screen 6 is placed on the rest 5 in the direction indicated by the arrow B. At this time, the contact screen 6 is placed on the rest 5 while being guided by the lower roller 12 provided on the base 4, and the screen frame 37 is set such as to abut against and be secured to the ruling side 42, as described above.

When the light shielding frame 9 is closed, the contact screen 6 is clamped by the rollers 12, 12, the space is covered by the rest 5 and the light

shielding cover sheet 7 moves into a light shielding range and ensured as light sealed state. In order to heighten the light sealing function, a light sealing member 41 formed of sponge or the like may be pasted around the lower surface of the L-shaped frame member 8 with the light shielding cover sheet 7 stretched thereover, as is shown in Fig. 4. Prior to placing the photosensitive lithographic printing plate 1 on the rest 5, the frame member 8 on the plate 1 supplying side is lifted up by the controlling means. A predetermined length of the plate 1 is next supplied by driving the supply rollers 32 of the cassette 2 (at this time the feed rollers 11 are interlocked), and is cut by the cutter 31 after suspension of the operation of the supply rollers 32 and the feed rollers 11.

When the photosensitive lithographic printing plate 1 has been cut, the feed rollers 11 alone are driven again in order to feed the plate 1 onto the contact screen 6 on the rest 5 with the photosensitive surface down, the plate 1 thereby being overlaid with the contact screen 6. In the state where feeding is finished, the feed rollers 11, 11 clamp the plate 1 in the vicinity of its end which is out of the effective image range, as is shown in Fig. 3, thereby preventing movement of the plate 1 at the time of, for example, drawing out the contact screen 6.

The light shielding cover sheet 7 which is

stretched over the frame member 8 is lowered by operating the knob 36' of the controlling means. The space enclosed by the rest 5 and the light shielding cover sheet 7 is evacuated by driving a vacuum suction device such as a vacuum pump (not shown), whereby the contact screen 6 and the plate 1 placed on the rest 5 are brought into close contact.

An original bearing continous tone color photographs or images and scattered line drawings of letters in black was mounted on the rack 27. Heading letter A, heading letter B, and text letter C were to be printed in red, green, and black, respectively. Accordingly, yellow, magenta, cyan, and black plates were prepared by exposing in the order and under the conditions as shown in the following table.

In exposing each plate by using the contact plate the letter copy was masked and in exposing the letter copy, the portion of the photographic copy and an unnecessary letter copy were masked.

| Plate | Exposure | Copy | Color Filter | Et(sec) | f(sec) |
|---|---|---|---|---|---|
| Cyan | (1)<br>(2) | Photograph<br>Letter B | No. 25<br>No. 25 | 25<br>3.3 | 3.7<br>-- |
| Magenta | (1)<br>(2) | Photograph<br>Letter A | No. 58<br>No. 58 | 30<br>4 | 3.6<br>-- |
| Yellow | (1)<br>(2)<br>(2) | Photograph<br>Letter A<br>Letter B | No. 47B<br>No. 47B<br>No. 47B | 112<br>7<br>7 | 3<br>-<br>- |
| Black | (1)<br>(2) | Photograph<br>Letter C | No. 85B<br>No. 85B | 60<br>3.5 | 3<br>- |

The referential numeral (1) means "with a contact screen", and (2) "without a contact screen".

The photograph in the original was photographed by main exposure (Et) and flash exposure (f). The exposure was performed at a stop f=16. The contact screen employed was a model GCDN (150 lines/inch) produced by Dainippon Screen manufacturing Co., Ltd. The screen angles were varied as follows: 15° for a cyan plate, 45° for a magenta plate, 0° for a yellow plate, and 75° for a black plate.

In exposure of each color plate, the photographic copy was first exposed through the contact screen 6, and thereafter the close contact of the plate 1 and the contact screen 6 produced by means of the vacuum suction device was released and the contact

screen 6 was drawn out of the photographing section 3 by gripping the pull 38 before the line images of the letters were exposed on the same plate 1. Since the contact screen 6 was clamped by the rollers 12, 12 at this time, the light sealing state was not impaired, and since the end of the plate 1 was clamped by the feed rollers 11, 11, there was no risk of the plate 1 deviating from its position.

When releasing the above-described close vacuum applied contact, it is preferable to release it rapidly, not only by suspending the operation of the vacuum suction device, but also by using a device having an air supply function like the vacuum suction device. Rapid and complete release of the vacuum applied adhered state is effective from the viewpoint of preventing scumming of the plate 1 and damage of the contact screen 6, either of which may be caused by friction between the photosensitive plate 1 which contains fine powder for the purpose of water retention (prevention of scumming) and the contact screen 6 when the contact screen 6 is drawn out.

Thereafter the plate 1 was brought into close contact with the rest 5 by driving the vacuum suction device again and the line image was photographed.

Each color plate exposed to the original was carried to the plate processing section 40 through a discharge passage 50 by reverse driving of the feed

rollers 11, and was processed there. The plate processing section 40 has the following treatment liquids built-in.

Developer:

| | |
|---|---|
| Water | 700 mℓ |
| Potassium hydroxide | 20 g |
| Anhydrous sodium sulfite | 50 g |
| 2-Mercaptobenzoic acid | 1.5 g |
| 2-Methylaminoethanol | 15 g |
| Made up with water to | 1 liter |

Neutralizer:

| | |
|---|---|
| Water | 600 mℓ |
| Citric acid | 10 g |
| Sodium citrate | 35 g |
| Colloidal silica (20% suspension) | 5 mℓ |
| Ethylene glycol | 5 mℓ |
| Made up with water to | 1 liter |

Desensitizer:

| | |
|---|---|
| Water | 600 mℓ |
| Isopropyl alcohol | 400 mℓ |
| Ethylene glycol | 50 g |
| 3-Mercapto-4-acetamido-5-n-heptyl-1,2,4-triazole | 1 g |

Each lithographic printing plate was inked with an offset printing ink of the corresponding color and superposed multicolor printing was performed. The reproducibility of the letter original was of course excellent. The color reproducibility of a multicolor original was also excellent, the dot area distribution being in the range of from 5 to 95%. The printing endurance was as high as 30,000 or more in terms of the number of copies obtainable.

In the above-described method for the direct production of printing plates, after exposure of a continuous color tone photographs on the lithographic plate through the contact screen, the contact screen was drawn out of the photographing section, and thereafter the line image was exposed. It goes without saying that exposure of the continuous tone image after the exposure of the line image is also possible. In this case, a lithographic plate is first placed in the light shielded portion or area on the rest, the line image is exposed in the state where the plate is in close contact with the rest by causing a vacuum. The vacuum is next released while maintaining the light shielded portion in the light shielded state, and the contact screen which is stretched over the screen frame is inserted into the light shielded portion to be overlaid with the plate. After the light shielded portion is evacuated so as to bring the contact screen in close contact with the

plate, the continuous tone image is exposed, and thereafter the plate is subjected to plate processing.

A method for plate making according to the invention does not necessarily use the above-described porcessor shown in Figs. 1 to 4, and various modified methods may be adopted.

In Fig. 3, the pair of rollers 12, 12 for drawing out the contact screen 6 may be disposed on the side facing the feed rollers 11, 11 for feeding and discharging the plate 1. Further, it is possible to provide another similar pair of rollers on the side facing the pair of rollers 12, 12 shown in Fig. 3. In this case, by connecting one or more kinds of contact screen with a transparent sheet (in the case of using more than two kinds of contact screens a transparent sheet is provided between each contact screen) to make an object of continuous length, it is possible to first expose the line image on the plate 1 (a transparent sheet exists under the plate 1) and to next expose the continuous tone image through the screen by inserting the predetermined screen under the plate 1 while moving the object of continuous length. This method does not necessarily involve the use of the pair of rollers 12, 12, which, together with the light shielding cover sheet 7, bring about the light shielding state (light sealing state); and they may be replaced by a lightproof soft material such as sponge, and further it is possible to

produce the light shielded state substantially by the use of light shielding cover sheet 7 alone.

In the above-described embodiment the frame membe with the light shielding cover sheet stretched over is lifted up when the plate is carried and placed onto the rest, but it is possible to dispense with the frame member by directly stretching the light shielding cover sheet over the light shielding frame itself.

COMPARISON

For comparison, a magenta plate was made in the same manner as described above, except that the original was halftone dot image (150 lines/inch; 5 to 95% dot area) formed on a positive sheet of silver complex diffusion transfer process, and neither a contact screen nor flash exposure was used. Printing test was run using the resulting magenta printing plate (50% dot). The highlight areas (5 to 20% dot) were not reproduced and no halftone area was observed in the shadow areas. The halftone dot image (80 to 95% dot) was disappeared before 20,000 copies had been printed.

As described above, in the processor shown in Figs. 1 to 4, the plate 1 is transferred to the plate processing section 40 by the reverse driving of the feed rollers 11, 11 after the end of the exposure of the continuous tone image and the line image. Figs. 5 to 8 show various examples of the structure for enabling the

plate to be satisfactorily supplied and transferred from the photographing section 3 to the plate treatment portion 40 by the feed rollers 11, 11.

In the structure shown in Fig. 5, a movable guide member 51, which serves partially both as a lower guide 29a of a plate supply passage and an upper side 50a of the plate discharge passge 50, is provided in such a manner that, at the time of supplying and discharging the plate 1, it is switchable in association with the feed rollers 11 between portion indicated by the solid line and the portion indicated by the broken line by means of, for example, a rotary solenoid, the support point F acting as an axis.

Fig. 6 shows a structure in which an elastic sheet material 52 which extends such as to approximately cover the end portion of the supply passage is provided on the upper guide 50b of the discharge passage 50. In this strucure, the plate 1 is supplied to the photographing section 3 by the feed rollers 11, 11 while elastically transforming the sheet material 52, and is introduced to the plate processing portion 40 on the underside of the elastic sheet material 52 at the time of the reverse driving of the feed rollers 11, 11. Referring to Fig. 7, the end portion of the lower guide 29b of the supply passage and the corresponding end portion of the upper guide 50c of the discharge passage 50 are connected by a connecting board 53 such that the

0165591

upper end portion of the connecting board 53 is situated slightly above the nip between the rollers 11, 11. Fig. 8 shows the structure in which the left end of the lower guide 50d of the discharge passage is situated slightly below the nip between the rollers 11, 11, and the left end of the lower guide 29d of the supply passage and the left end of the upper guide 50d of the discharge passage are connected at a position 54 considerably apart and to the right of the rollers 11, 11 such as to form a common passage 54 to the supply passage and the discharge passage between the rollers 11, 11 and the connecting portion 54. It will be obvious that a good supply and discharge of the plate 1 by the feed rollers 11, 11 is enabled by appropriately adopting the structures shown in Figs. 5 to 8.

A method for the direct making of printing plates according to the invention has the following advantages.

(a) By using a contact screen for a photosensitive lithographic plate for a direct platemaking process, reproduction of a halftone dot image of more than 133 lines/inch, which has conventionally been impossible, is realized and the printing plate exhibits improved printing endurance.

(b) A method for the direct production of printing plates which provides a multi-color print of good quality is enabled.

(c) It is unnecessary to make a block copy by converting a continuous tone image into a halftone dot image, which advantageously leads to reductions in labor and expenses.

(d) A contact screen can be drawn out or inserted in daylight, namely in the light shielded state, so that a continuous tone image and a line image can be exposed with a photosensitive lithographic printing plate fixed on the rest, and, in addition, the positional accuracy of those images are good, which means this method is particularly effective for a multi-color platemaking methode used for processing each plate of a plurality of colors.

(e) It is possible to perform the plate making operation in daylight, resulting in remarkable improvement in working efficiency.

While there has been described what is at present considered to be the preferred embodiments of the invention, it will be understood that various modifications may be made thereto, and it is intended that the appended claims cover all such modifications as fall within the true spirit and scope of the invention.

WHAT IS CLAIMED IS:

1. A method for the direct making of printing plates in which the steps of exposure of an image on a photosensitives lithographic plate and plate processng are conducted in daylight, said method comprising the steps of:

disposing said plate on a rest in an area where light is shielded by a light shielding cover sheet with a contact screen secured to a screen frame, said plate being overlaid with said contact screen;

exposing on said plate a continuous tone image of an original bearing the continuous tone image and a line image in the state wherein said area is evacuated and said plate and contact screen are in close contact;

releasing the vacuum within said area with the light shielded state being maintained, and drawing said screen frame integrally with said contact screen out of said portion; exposing on said plate said line image of said original in the state wherein said portion is evacuated and said plate and said rest are in close contact; and

feeding said plate after the exposure to a plate processing section and processing said plate there.

2. A method for the direct making of printing plates in which the steps of exposure of an image on a photosensitive lithographic plate and plate processing

are conducted in daylight, said method comprising the steps of:

disposing said plate on a rest in an area in which light is shielded by a light shielding cover sheet; exposing on said plate a line image of an original bearing a continuous tone image and the line image in the state where said area is evacuated and said plate and said rest are in close contact;

releasing the vacuum within said area with the light shielded state being maintained, and inserting into said area a contact screen which is secured to a screen frame and disposing said contact screen in overlapped relation with said plate;

exposing on said plate said continuous tone image of said original in the state where said area is evacuated and said plate and said contact screen are in close contact; and

feeding said plate after the exposure to a plate processing section and processing said plate there.

FIG. 1

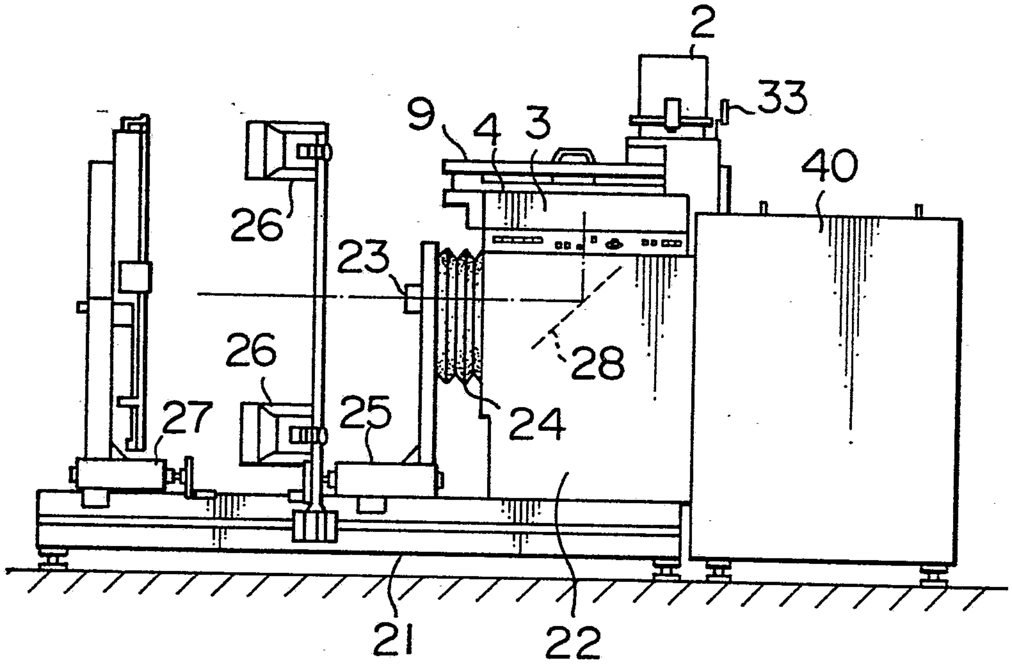

FIG. 2

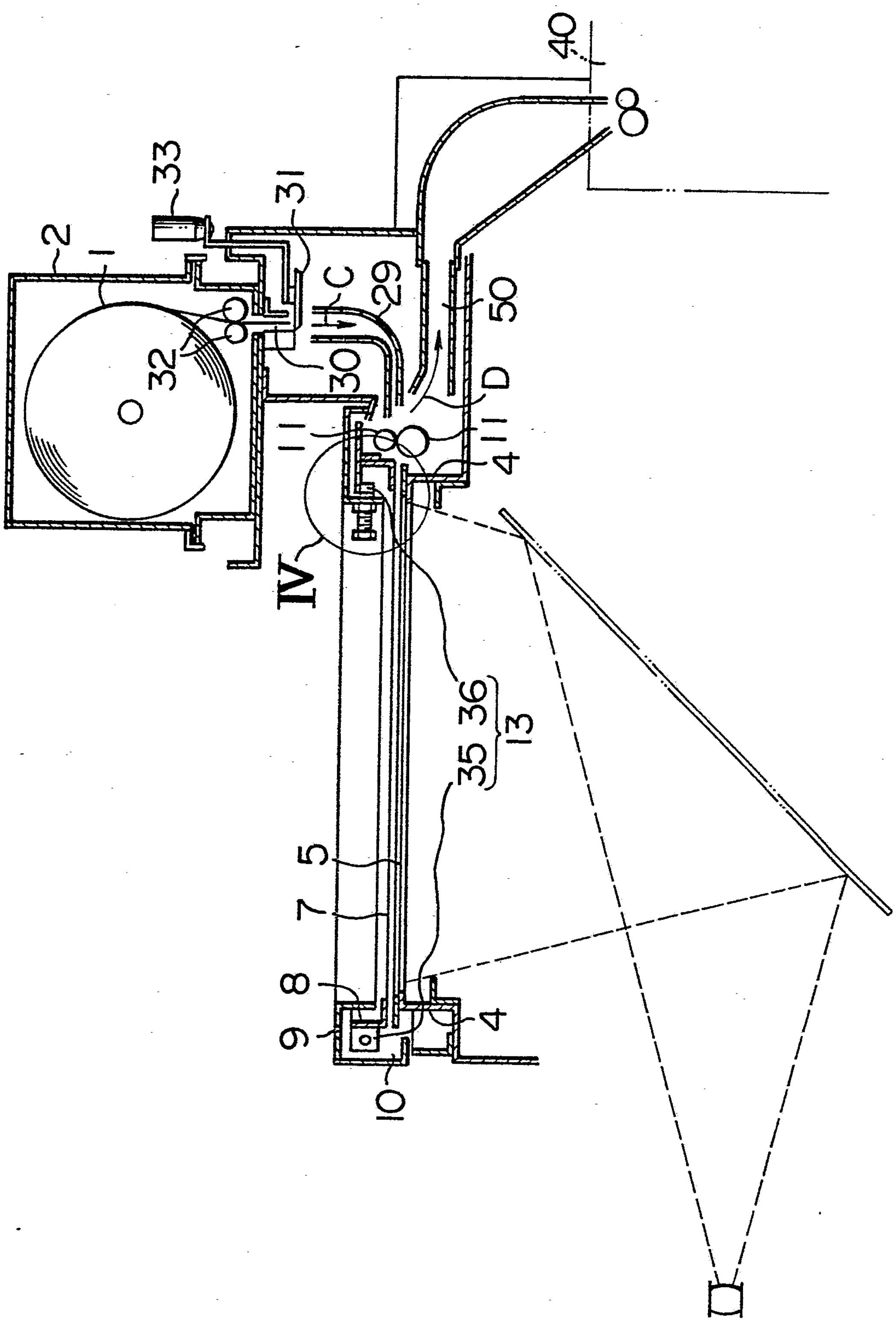

FIG.3

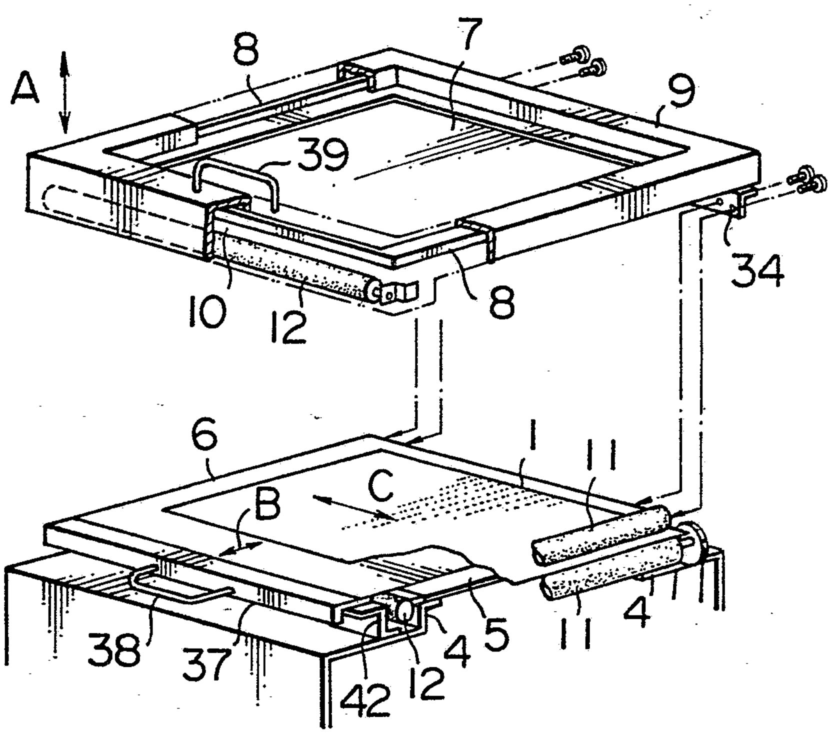


FIG.4

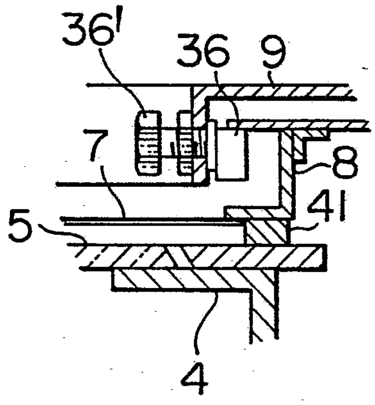

FIG.5

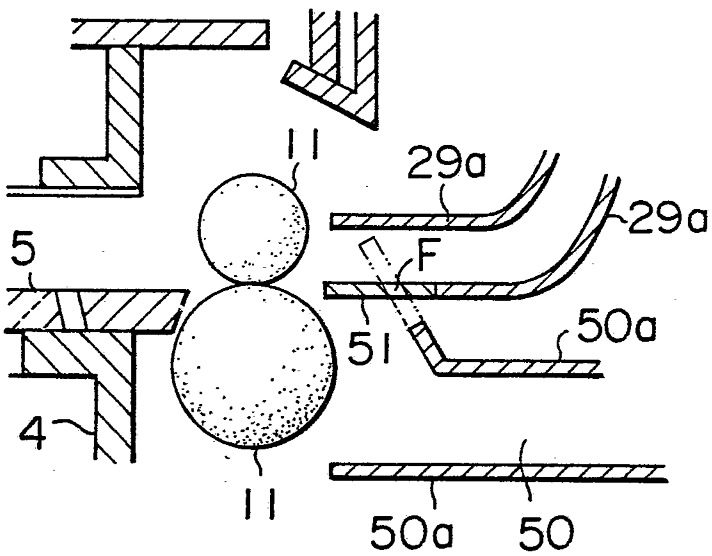


FIG.6

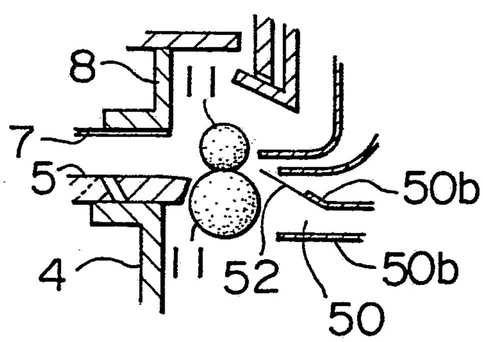

FIG.7

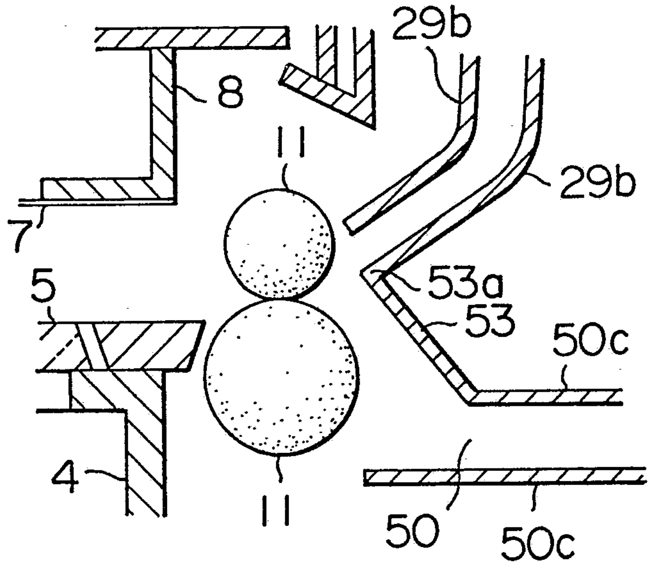
8
29b
29b
11
7
5
53a
53
50c
4
11
50
50c

FIG.8

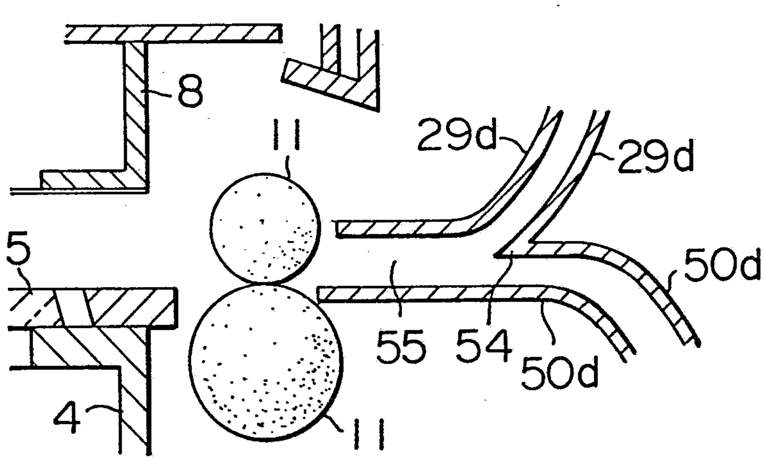
8
11
29d
29d
5
50d
55
54
50d
4
11